# EUROPÄISCHE PATENTANMELDUNG

(11) **EP 2 154 784 A1**
(43) Veröffentlichungstag der Anmeldung: **17.02.2010**
(21) Anmeldenummer: 09009842.7
(22) Anmeldetag: 30.07.2009
(51) Int. Cl.: H03K 17/12

(54) **Anordnung mit einer Treiberschaltung und mindestens einem Leistungsschalter sowie Ansteuerverfahren hierzu**

(30) Priorität: 16.08.2008 DE 102008038004
(71) Anmelder: SEMIKRON Elektronik GmbH & Co. KG, 90431 Nürnberg (DE)
(72) Erfinder: do Nacimento, Jair, 91077 Dormitz (DE); Schmitt, Stefan, 90766 Fürth (DE)

(57) **Zusammenfassung**

Die Erfindung beschreibt eine Anordnung mit einer Treiberschaltung und einem Leistungsschalter, wobei der Leistungsschalter als eine Parallelschaltung eines ersten schaltbaren Leistungshalbleiterbauelements (32) und eines zweiten schaltbaren Leistungshalbleiterbauelements (34) ausgebildet ist. Wesentlich ist hierbei, dass das erste Leistungshalbleiterbauelement (32) geringere Schaltverluste und / oder eine geringere Schwingungsneigung beim Schalten aufweist als das zweite Leistungshalbleiterbauelement (34), während das zweite Leistungshalbleiterbauelement (34) geringere Durchlassverluste als das mindestens eine erste Leistungshalbleiterbauelement (32) aufweist. Das zugehörige Verfahren schaltet bei einem Schaltimpuls (220) das erste Leistungshalbleiterbauelement (32) für eine definierte Zeitspanne an und während dieser Zeitspanne erhält das zweite Leistungshalbleiterbauelement (34) ebenfalls einen Schaltimpuls (240).

## Beschreibung

Die Erfindung beschreibt eine Anordnung mit einer Treiberschaltung und mindestens einem Leistungsschalter, der vorzugsweise Bestandteil eines Leistungshalbleitermoduls ist. Derartige Leistungshalbleitermodule sind vielfältig bekannt und weisen häufig eine Halb- oder Dreiphasentopologie auf. Der hier beschriebene Leistungsschalter bildet somit einen Grundbaustein eines derartigen Leistungshalbleitermoduls aus. Weiterhin beschreibt die Erfindung ein besonders zweckmäßiges Verfahren zur Ansteuerung des erfindungsgemäßen Leistungsschalters.

Leistungshalbleitermodule der genannten Art sind beispielhaft aus der EP 0 750 345 A2 bekannt. Hier wird ein Leistungsschalter gebildet aus einem Leistungstransistor mit einer antiparallel geschalteten Leistungsdiode. Es ist, beispielhaft aus der gleichen Druckschrift auch bekannt derartige Leistungsschalter als eine Parallelschaltung mehrerer identischer Leistungstransistoren mit einer Mehrzahl identischer Leistungsdioden auszubilden.

Aus der DE 100 10 957 A1 sind Leistungsschalter bekannt, die aus einer Parallelschaltung mindestens eines MOS-FET und mindestens eines IGBT bestehen. Dieser Leistungsschalter dient in der Anwendung in einem Wechselrichter dazu bei hohen Schaltfrequenzen eine große Stromtragfähigkeit zu erzielen. Diese Ausgestaltung ist allerdings beschränkt auf relativ niedrige Versorgungsspannungen, bei denen MOS-FETs, die bekanntermaßen eine geringe Spannungsfestigkeit im Vergleich zu IGBTs aufweisen, eingesetzt werden können. In dieser Ausgestaltung werden bei einem Einschaltbefehl beide Teilschalter gleichzeitig eingeschaltet und bei einem anschließenden Ausschaltbefehl der MOS-FET zeitverzögert zum IGBT wieder ausgeschaltet.

Die Leistungsschalter in modernen Leistungshalbleitermodulen werden mit Schaltfrequenzen von bis zu 20kHz geschaltet. Während der Schaltvorgänge treten bei verschiedenen Ausgestaltungen von Leistungstransistoren hochfrequente Schwingungen auf, die zu einer erheblichen Abstrahlung in Form elektromagnetischer Wellen führen. Diese Störabstrahlung zu minimieren ist eine Aufgabe beim Systemeinsatz von Leistungshalbleitermodulen im Verbund mit weiteren Bauelementen, wie Treiberschaltungen und Kondensatoren. Das sog. EMV- (Elektromagnetische Verträglichkeit) Verhalten eines Leistungshalbleitermoduls in einer Systemanwendung wird bestimmt durch die Stromamplitude, die Spannungsamplitude, das Tastverhältnis der Ansteuerung, die Schaltfrequenz sowie durch die Schaltzeiten der Leistungsschalter.

Eine Verbesserung des EMV Verhaltens sollte daher in einem System, unter anderem bestehend aus einem Leistungshalbleitermodul, bereits an den Stellen erfolgen, an denen die Störungen ursächlich entstehen. Die Einflussmöglichkeiten auf Leistungshalbleitermodulebene sind allerdings stark begrenzt, da viele der genannten Faktoren durch die Anwendung definiert werden und somit nicht veränderbar sind.

Weiterhin sind einzelne Leistungshalbleitertransistoren auf einen wesentlichen Parameter, wie beispielsweise geringe Durchlassverluste oder geringe Schaltverluste hin optimiert, wodurch in der Regel der jeweils andere Parameter schlechtere Werte aufweist, als bei einem hierauf optimierten Leistungstransistor.

Der Erfindung liegt die Aufgabe zugrunde ein Ansteuerverfahren für und eine Anordnung mit mindestens einem Leistungsschalter für ein Leistungshalbleitermodul und mit einer Treiberschaltung vorzustellen, wobei der Leistungsschalter in Verbindung mit dem Ansteuerverfahren mittels der Treiberschaltung ein verbessertes Schaltverhalten aufweist.

Diese Aufgabe wird erfindungsgemäß gelöst, durch den Gegenstand mit den Merkmalen des Anspruchs 1 sowie durch ein Verfahren nach Anspruch 3. Bevorzugte Ausführungsformen sind in den abhängigen Ansprüchen beschrieben.

Den Ausgangspunkt der Erfindung bilden Leistungshalbleiterbauelemente in Form von Leistungstransistoren, wobei die Erfindung nicht auf diese Art der Leistungsschalter beschränkt ist, von denen bekannt ist, dass es erste Ausgestaltungen gibt, die auf möglichst geringe Schaltverluste optimiert sind und zweite Ausgestaltungen, die auf möglichst geringe Durchlassverluste optimiert sind.

Unter Schaltverlusten soll im Weiteren derjenige Verlust an elektrischer Energie verstanden werden, der während des Schaltens eine Leistungsschalters in einem beispielhaften Zeitraum von einigen Hundert Nanosekunden in diesem Leistungsschalter verbraucht wird und als Wärme abzuführen ist. Typische Werte liegen in der Größenordnung von einigen Millijoule.

Unter Durchlassverlusten soll im Weiteren derjenigen Verlust an elektrischer Energie verstanden werden, die während der Leitungsphase eines Leistungsschalters in einem typischen Zeitraum von bis zu einigen Hundert Millisekunden in diesem Leistungsschalter verbraucht wird und als Wärme abzuführen ist. Typische Werte liegen hier bei bis zu einigen Zehn Millijoule.

Somit weist eine erfindungsgemäße Anordnung mit einer Treiberschaltung und mindestens einem Leistungsschalter einen jeweiligen Leistungsschalter auf, der als eine Parallelschaltung mindestens eines ersten schaltbaren Leistungshalbleiterbauelements und mindestens eines zweiten schaltbaren Leistungshalbleiterbauelements ausgebildet ist. Zur individuellen Ansteuerung der jeweiligen ersten und zweiten Leistungshalbleiterbauelemente weisen diese jeweils eine Steuerverbindung zur Treiberschaltung auf. Wesentlich hierbei ist, dass das mindestens eine erste Leistungshalbleiterbauelement geringere Schaltverluste und / oder eine geringere Schwingungsneigung beim Schalten als das mindestens eine zweite Leistungshalbleiterbauelement aufweist, während
das mindestens eine zweite Leistungshalbleiterbauelement geringere Durchlassverluste als das mindestens eine erste Leistungshalbleiterbauelement aufweist.

Bei dem erfindungsgemäßen Verfahren zur Ansteuerung einer derartigen Anordnung wird von einer mit der Treiberschaltung verbindbaren Steuerung ein Schaltbefehl erzeugt und an die Treiberschaltung übermittelt. Daraufhin schaltet die Treiberschaltung das mindestens eine erste Leistungshalbleiterbauelement für eine definierte Zeitspanne an und während dieser Zeitspanne erhält das mindestens eine zweite Leistungshalbleiterbauelement ebenfalls einen Schaltimpuls. Somit nutzt dieses Ansteuerverfahren bei Schaltvorgängen die geringen Schaltverluste und / oder die geringere Schwingungsneigung des mindestens einen ersten Leistungshalbleiterbauelements und erzeugt somit im zweiten Fall eine geringere Störabstrahlung als beim direkten Schalten des mindestens einen zweiten Leistungshalbleiterbauelements Im ersten Fall werden die Gesamtverluste des Leistungsschalters, gebildet aus den Durchlass- und den Schaltverlusten wesentlich verbessert. Vorzugweise weist das mindestens eine erste Leistungshalbleiterbauelement die beiden Vorteile der geringeren Schaltverluste und der geringeren Schwingungsneigung gemeinsam auf. Derartige erste Leistungshalbleiterbauelemente weisen dann allerdings deutlich höhere Leitungsverluste auf als ein hierauf optimiertes zweites Leistungshalbleiterbauelement. Das mindestens eine zweite Leistungshalbleiterbauelement wird also in derjenigen Zeitspanne geschaltet, in der das erste kontinuierlich angeschaltet ist, wodurch die Schaltverluste des zweiten Leistungshalbleiterbauelements nicht zum Tragen kommen.

Das erste Leistungshalbleiterbauelement ist somit immer nur während der Zeitspanne eingeschaltet, während das zweite Leistungshalbleiterbauelement einen Schaltimpuls bekommen soll, damit kommen die schlechteren Durchlassverluste des erste Leistungshalbleiterbauelements nicht zum Tragen. Somit werden entweder Störabstrahlung oder die Schaltverluste oder beides während der Schaltphasen des Leistungsschalters verringert ohne die sonstigen positiven Eigenschaften, wie geringe Durchlassverluste im eingeschalteten Zustand, negativ zu beeinflussen, da hier das erste Leistungshalbleiterbauelement nicht mehr eingeschaltet ist.

Bei einem Einschaltbefehl für den Leistungsschalter wird somit von der Treiberschaltung das mindestens eine erste Leistungshalbleiterbauelement für eine ersten Zeitspanne eingeschaltet und während dieser Zeitspanne zu einem definierten Zeitpunkt das mindestens eine zweite Leistungshalbleiterbauelement ebenfalls eingeschaltet.

Bei einem Ausschaltbefehl für den Leistungsschalter wird somit von der Treiberschaltung das mindestens eine erste Leistungshalbleiterbauelement für eine zweiten Zeitspanne eingeschaltet, wobei in dieser Zeitspanne das mindestens eine zweite Leistungshalbleiterbauelement noch eingeschaltet ist und während dieser Zeitspanne zu einem definierten Zeitpunkt wird das mindestens eine zweite Leistungshalbleiterbauelement ausgeschaltet.

Mittels des erfindungsgemäßen Verfahrens werden das mindestens eine erste und das mindestens eine zweite Leistungshalbleiterbauelement derart angesteuert, dass die Gesamtverluste eines Schaltvorgangs deutlich geringer sind als bei einer Ausgestaltung des Leistungsschalters gemäß dem Stand der Technik. In den meisten bekannten Leistungshalbleitermodulen ist jeder Leistungsschalter als eine Mehrzahl von gleichen Leistungshalbleiterbauelementen ausgebildet, welche immer auf einen Parameter, wie geringe Durchlassverluste oder geringe Schaltverlust optimiert ist. Daher muss das Leistungshalbleitermodul bezüglich seiner Wärmeabfuhr auf den nicht optimierten Parameter ausgelegt werden, um auch hier die Verluste in Form von Wärme abführen zu können. Eine erfindungsgemäße Ausgestaltung eines Leistungsschalters bedingt somit nicht zwangsläufig eine Verdoppelung der Leistungshalbleiterbauelemente pro Schalter, da hier die für die Auslegung eines Leistungshalbleitermoduls zu beachtenden Gesamtverluste pro Leistungsschalter geringer sind.

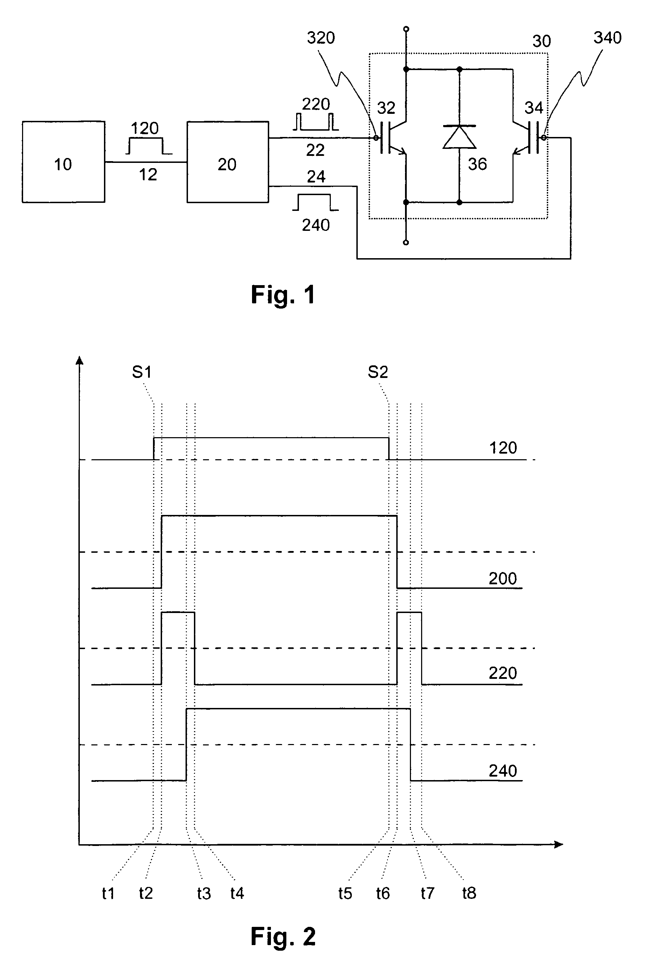

Besonders bevorzugte Weiterbildungen dieser Schaltungsanordnung und deren Ansteuerverfahren sind in der jeweiligen Beschreibung der Ausführungsbeispiele genannt. Die erfinderische Lösung wird zudem an Hand der Ausführungsbeispiele der Fig. 1 und 2 weiter erläutert.

Fig. 1 zeigt eine Ausgestaltung einer erfindungsgemäßen Anordnung mit einer verbindbaren Steuerung.

Fig. 2 zeigt die Pulsverläufe einer Ausgestaltung des erfindungsgemäßen Ansteuerverfahrens.

Fig. 1 zeigt eine Ausgestaltung einer erfindungsgemäßen Anordnung mit einer verbindbaren Steuerung (10). Die Anordnung weist hierbei eine Treiberschaltung (20) auf, die von einer übergeordneten Steuerung (10) über einen Datenkanal (12) Steuerbefehle (120) für einen Leistungsschalter empfängt.

Die Treiberschaltung (20) bereitet diese Steuerbefehle in Ansteuersignale für den Leistungsschalter (30) auf. Der Leistungsschalter (30) ist hierbei erfindungsgemäß ausgebildet als eine Parallelschaltung mindestens eines ersten schaltbaren Leistungshalbleiterbauelements (32) und mindestens eines zweiten schaltbaren Leistungshalbleiterbauelements (34). Hierbei ist das erste Leistungshalbleiterbauelement (32) dadurch charakterisiert, dass es geringere Schaltverluste und eine geringere Schwingungsneigung aufweist als das zweite Leistungshalbleiterbauelement (34). Dementsprechend ist das zweite Leistungshalbleiterbauelement (34) dadurch charakterisiert, dass es geringere Durchlassverluste als das erste Leistungshalbleiterbauelement (32) aufweist.

Da hier beide Leistungshalbleiterbauelemente (32, 34) als IGBTs, hergestellt in unterschiedlichen Technologien, ausgebildet sind ist noch eine Leistungsdiode (36) für den Freilauffall antiparallel zu den beiden Leistungshalbleiterbauelementen (32, 34) geschaltet. Hierbei handelt es sich um die einfachste Ausgestaltung des erfindungsgemäßen Leistungsschalters (30). Selbstverständlich kann bei weiteren Ausgestaltungen die Anzahl der ersten (32) und zweiten (34) Leistungshalbleiterbauelemente unterschiedlich sein. Die mindestens eine antiparallel geschaltete Leistungsdiode (36) kann bei geeigneten schaltbaren Leistungshalbleiterbauelementen, wie Reverse- blocking- IGBTs oder MOS-FETs auch gänzlich entfallen.

Die beiden ersten und zweiten Leistungshalbleiterbauelemente (32, 34) sind mittels einer ihnen jeweils zugeordnete Steuerverbindung (22, 24) mit der Treiberschaltung (20) verbunden.

Fig. 2 zeigt schematisch die Pulsverläufe, des Steuerbefehls (120) von der Ansteuerung zur Treiberschaltung, sowie die Pulsverläufe der Ansteuersignale (220, 240) des ersten (32) und zweiten (34) Leistungshalbleiterbauelements, einer Ausgestaltung des erfindungsgemäßen Ansteuerverfahrens. Vergleichend dargestellt ist der Pulsverlauf eines Ansteuersignals (200) für einen Leistungsschalter nach dem Stand der Technik.

Die Ansteuerung (10) sendet zu einem Zeitpunkt (t1) einen Schaltbefehl, hier einen Einschaltbefehl (S1). Nach einer Reaktionszeit der Treiberschaltung (20) sendet diese zum Zeitpunkt (t2) einen Einschaltbefehl zum ersten Leistungshalbleiterbauelement (32) wodurch dieses den Stromfluss durch den Leistungsschalter (30) freigibt.

Anschließend sendet die Treiberschaltung (20) zu einem Zeitpunkt (t3) den Einschaltbefehl zum zweiten Leistungshalbleiterbauelement (34), wodurch dieses ebenfalls leitend geschaltet wird. Hierbei sind dessen Schaltverluste unerheblich, da der Strom bereits durch den Leistungsschalter fließt.

Um die Durchlassverluste des ersten Leistungshalbleiterbauelements (32) zu vermeiden wird dieses zu einem Zeitpunkt (t4) von der Treibschaltung (20) wieder ausgeschaltet, wonach der gesamte Strom über das zweite Leistungshalbleiterbauelement (34) fließt. Das erste Leistungshalbleiterbauelement (32) war somit nur für die Zeitspanne (t4-t2) aktiv.

Zu einem Zeitpunkt (t5) sendet die Ansteuerung (10) einen weiteren Schaltbefehl, einen Ausschaltbefehl (S2) an die Treiberschaltung (20). Nach einer erneuten Reaktionszeit der Treiberschaltung (20) sendet diese zum Zeitpunkt (t6) einen Einschaltbefehl zum ersten Leistungshalbleiterbauelement (32), wodurch nun wieder beide Leistungshalbleiterbauelemente (32, 34) Strom führen.

Anschließend wird durch die Treiberschaltung (20) zum Zeitpunkt (t7) das zweite Leistungshalbleiterbauelement (34) ausgeschaltet, wobei der Strom nun nur noch über das erste Leistungshalbleiterbauelement (32) fließt.

Dieses erste Leistungshalbleiterbauelement (32) wird nun zu einem Zeitpunkt (t8) ebenfalls ausgeschaltet, wobei es nur während der zweiten Zeitspanne (t8-t6) aktiv war. Durch dieses Ausschalten des ersten Leistungshalbleiterbauelements (32) wird der Leistungsschalter (30) als solcher ausgeschaltet.

Typische Werte für Schaltfrequenzen des Leistungsschalters (30) im Bereich von 10kHz liegen für die erste und zweite Zeitspanne (t4-t2, t8-t6) zu denen das erste Leistungshalbleiterbauelement (32) eingeschaltet ist zwischen 1µs und 5µs während die weitere Zeitspanne (t7-t3) während der das zweite Leistungshalbleiterbauelement (34) eingeschaltet war bis zu 500µs beträgt. Selbstverständlich kann es im realen Betrieb für den Leistungsschalter (30) derart kurze Einschaltzeitspannen geben, in denen der zweite Schalter nicht geschaltet wird.

## Patentansprüche

1. Anordnung mit einer Treiberschaltung (20) und mindestens einem Leistungsschalter (30), wobei der Leistungsschalter (30) als eine Parallelschaltung mindestens eines ersten schaltbaren Leistungshalbleiterbauelements (32) und mindestens eines zweiten schaltbaren Leistungshalbleiterbauelements (34) ausgebildet ist, die jeweils ersten und zweiten Leistungshalbleiterbauelemente (32, 34) jeweils eine ihnen zugeordnete Steuerverbindung (22, 24) zur Treiberschaltung (20) aufweisenden und
wobei
das mindestens eine erste Leistungshalbleiterbauelement (32) geringere Schaltverluste und / oder eine geringere Schwingungsneigung beim Schalten aufweist als das mindestens eine zweite Leistungshalbleiterbauelement (34), während
das mindestens eine zweite Leistungshalbleiterbauelement (34) geringere Durchlassverluste als das mindestens eine erste Leistungshalbleiterbauelement (32) aufweist.

2. Anordnung nach Anspruch 1,
wobei antiparallel zu dem mindestens einen ersten (32) und mindestens einen zweiten (34) Leistungshalbleiterbauelement mindestens ein drittes Leistungshalbleiterbauelement (36), eine Leistungsdiode geschaltet ist.

3. Verfahren zur Ansteuerung einer Anordnung nach einem der Ansprüche 1 oder 2,
wobei bei einem Schaltbefehl (S1, S2) einer mit der Treiberschaltung (20) verbindbaren Steuerung (10) die Treiberschaltung (20) das mindestens eine erste Leistungshalbleiterbauelement (32) für eine definierte Zeitspanne (t4-t2, t7-t5) anschaltet und während dieser Zeitspanne zu einem Zeitpunkt (t3, t6) das mindestens eine zweite Leistungshalbleiterbauelement ebenfalls einen Schaltimpuls erhält.

4. Verfahren nach Anspruch 3,
wobei bei einem Einschaltbefehl (S1) zu einem Zeitpunkt (t1) für den Leistungsschalter (30) von der Treiberschaltung (20) das mindestens eine erste Leistungshalbleiterbauelement (32) für eine erste Zeitspanne (t4-t2) eingeschaltet wird und während dieser Zeitspanne (t4-t2) zu einem Zeitpunkt (t3) das mindestens eine zweite Leistungshalbleiterbauelement (34) eingeschaltet wird.

5. Verfahren nach Anspruch 3,
wobei bei einem Ausschaltbefehl (S2) zu einem Zeitpunkt (t5) für den Leistungsschalter (30) von der Treiberschaltung (20) das mindestens eine erste Leistungshalbleiterbauelement (32) für eine zweite Zeitspanne (t8-t6) eingeschaltet wird, wobei hier das mindestens eine zweite Leistungshalbleiterbauelement (34) noch eingeschaltet ist und während dieser Zeitspanne (t8-t6) zu einem Zeitpunkt (t7) das mindestens eine zweite Leistungshalbleiterbauelement (34) ausgeschaltet wird.

6. Verfahren nach Anspruch 3,
wobei bei Schaltfrequenzen des Leistungsschalters (30) im Bereich von 10kHz die erste und zweite Zeitspanne (t4-t2, t8-t6) zu der das mindestens eine erste Leistungshalbleiterbauelement (32) eingeschaltet ist zwischen 1µs und 5µs liegen und die weitere Zeitspanne (t7-t3) in der das mindestens eine zweite Leistungshalbleiterbauelement (34) eingeschaltet ist bis zu 500µs beträgt.
